# EUROPEAN PATENT SPECIFICATION

(11) **EP 3 685 445 B1**
(45) Date of publication and mention of the grant of the patent: **17.12.2025**
(21) Application number: 18789504.0
(22) Date of filing: 20.09.2018
(51) Int. Cl.: H10F 71/00, H10F 10/165, H10F 77/20

(54) **INTERDIGITATED BACK-CONTACTED SOLAR CELL WITH P-TYPE CONDUCTIVITY**
INEINANDERGREIFENDE RÜCKKONTAKTIERTE SOLARZELLE MIT P-LEITFÄHIGKEIT
CELLULE SOLAIRE À CONTACT ARRIÈRE INTERDIGITÉ À CONDUCTIVITÉ DU TYPE P

(30) Priority: 22.09.2017 NL 2019617; 24.05.2018 NL 2020984
(43) Date of publication of application: 29.07.2020
(73) Proprietor: Nederlandse Organisatie voor toegepast- natuurwetenschappelijk Onderzoek TNO, 2595 DA 's-Gravenhage (NL)
(72) Inventor: BENDE, Evert Eugène, 1755 LE Petten (NL); WU, Yu, 1755 LE Petten (NL); ANKER, John, NL-1755 LE Petten (NL)
(74) Representative: Nederlandsch Octrooibureau
(86) International application number: PCT/NL2018/050621
(87) International publication number: WO 2019/059765

(56) References cited:
- EP-A2- 2 980 858
- WO-A1-2013/096500
- WO-A1-2017/058011
- AU-A1- 2008 202 346
- CN-A- 102 856 328
- US-A1- 2014 096 821
- YANG GUANGTAO ET AL: "IBC c-Si solar cells based on ion-implanted poly-silicon passivating contacts", SOLAR ENERGY MATERIALS AND SOLAR CELLS, ELSEVIER SCIENCE PUBLISHERS, AMSTERDAM, NL, vol. 158, 26 May 2016 (2016-05-26), pages 84 - 90, XP029757039, ISSN: 0927-0248, DOI: 10.1016/J.SOLMAT.2016.05.041
- MAT DESA M K ET AL: "Silicon back contact solar cell configuration: A pathway towards higher efficiency", RENEWABLE AND SUSTAINABLE ENERGY REVIEWS, ELSEVIERS SCIENCE, NEW YORK, NY, US, vol. 60, 24 March 2016 (2016-03-24), pages 1516 - 1532, XP029505296, ISSN: 1364-0321, DOI: 10.1016/J.RSER.2016.03.004

## Description

### Field of the invention

The present invention relates to a back-contacted p-type solar cell. In addition, the invention relates to a solar panel or photovoltaic module comprising at least one such solar cell.

### Background

A conventional p-type IBC (Interdigitated Back-Contacted) solar cell has on its rear side regions of either a p-type base or diffused n-type emitter. It is a challenge to select a dielectric layer that can passivate both regions equally well. Most dielectric layers have a surface charge. Well-known passivating dielectric layer are aluminum oxide (alumina, Al₂O₃) with a negative surface charge and hydrogenated amorphous silicon nitride (a-SiNₓ:H) with a positive surface charge.

If Al₂O₃ is applied over the entire rear surface of a p-type IBC solar cell this has a beneficial effect on the surface recombination at the p-type base region. In that case electrons (minority carriers) are repelled while holes (majority carriers) are attracted, which is denoted as "accumulation". Since the minority carrier concentration is the limiting factor it determines the surface recombination rate. In this way, the surface recombination rate at the p-type base surface can be reduced, which contributes to a high open-circuit voltage. However, at the n-type region (the emitter) the mechanism works in the opposite direction. Here, holes (minority carriers) are attracted and electrons (majority carriers) are repelled. This increases surface recombination, since also here the minority carrier concentration, which are in this area the holes, sets the rate of recombination.

If the doping concentration of the n-type emitter decreases, which is usually beneficial for the reduction of surface recombination, the effect becomes stronger. The worst case occurs when the product of the concentration of electrons Nₑ and the capture cross section σₑ for electrons equals those parameters Nₕ, σₕ of holes (i.e. Nₑ σₑ = Nₕ σₕ).

This situation is denoted as "depletion", since the sum of concentration of electrons and holes is in that case minimal.

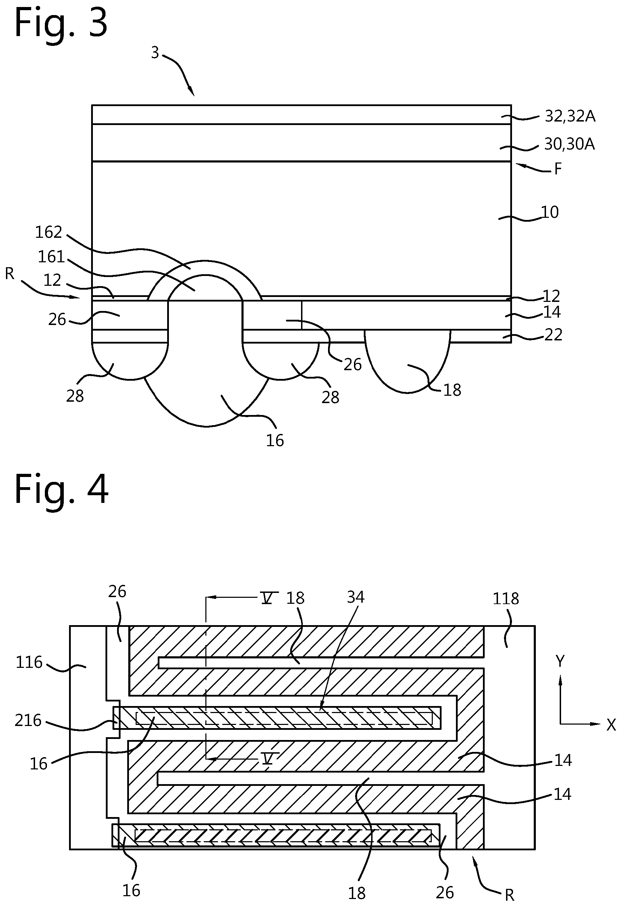

Hoex et al., in "Surface passivation of phosphorus-diffused n+-type emitters by plasma-assisted atomic-layer deposited Al2O3", Phys. Status Solidi RRL 6, No. 1, 4-6 (2012) / DOI 10.1002/pssr.201105445, show a minimum in implied V_{oc} of an non-metallized solar cell that illustrates this situation (Figure 3, ibid.).

Further reduction of the doping concentration leads to "inversion" in the emitter, which means that the electron concentration becomes lower than the hole concentration. This can be beneficial for surface recombination reduction, but leads to a non-functional solar cell.

If, on the contrary, a dielectric with a positive surface charge, like a-SiNₓ:H, is deposited on the p/n+ rear surface of the conventional p-type IBC cell, the physics work in the opposite way. The positive surface charge has beneficial effect on the emitter surface recombination and, in general, the surface recombination current j₀ decreases with decreasing doping surface concentration (which in practice means an increasing emitter sheet resistance).

However, on the lowly doped p-type substrate, typically having a resistivity of 1-3 Ω·cm, the strong positive surface charge leads to inversion. The implies that base surface region has become a surface-charge induced (i.e., non-diffused) emitter which extends towards the base contact. It is well known that this leads to shunts, causing extreme poor cell results.

A possible solution to the above problem is to create a dielectric layer with a (near-) zero surface charge. However, it has shown to be quite difficult to process these dielectric layers. Moreover, the quality of the passivation does not depend anymore on the field effect but only on the so-called "chemical passivation", which is in general much harder to realize. An example of such a layer is intrinsic amorphous silicon of which the chemical surface recombination is very good provided that the wet chemical pretreatment is of a very high standard. However, such a layer is known not to be stable at high temperatures and therefore not suitable in combination with mainstream firing process of screen-printed metal contacts.

US2014/096821 describes a solar cell including a doped layer disposed on a first surface of a semiconductor substrate, a doped polysilicon layer disposed in a first region of a second surface of the semiconductor substrate, a doped area disposed in a second region of the second surface, and an insulating layer covering the doped polysilicon layer and the doped area. The insulating layer has openings exposing portions of the doped polysilicon layer and the doped layer, and the doped polysilicon layer and doped layer are respectively connected to a first electrode and a second electrode through the openings.

CN102856328A describes a back-contacted solar cell based on a silicon substrate in which the rear surface is provided with a tunnel oxide layer and a doped polysilicon layer; the tunnel oxide layer and the doped polysilicon layer forming a patterned layer stack provided with gaps in the patterned layer stack, wherein an Al contact is arranged within each of the gaps, in electrical contact with a base layer of the substrate.

It is an object of the present invention to overcome or mitigate one or more of the problems of the prior art.

### Summary of the invention

The object is achieved by a back-contacted solar cell based on a silicon substrate of p-type conductivity having a front surface for receiving radiation and a rear surface; in which the rear surface is provided with a tunnel oxide layer and a doped polysilicon layer of n-type conductivity; the tunnel oxide layer and the doped polysilicon layer of n-type conductivity forming a patterned layer stack, is provided with gaps in the patterned layer stack; an Al-Si contact is arranged within each of the gaps, in electrical contact with a base layer of the substrate, and one or more Ag contacts is arranged on the patterned doped polysilicon layer and in electrical contact with the patterned doped polysilicon layer.

According to the invention, there is provided a p-type IBC solar cell with a patterned stack layer of tunnel oxide and n-type polysilicon emitter region. The tunnel-oxide is typically 0.5-2 nm thick and can be made by wet chemical oxidation (e.g. with a HNO₃ solution) or by gas-based oxidation at elevated temperatures.

In such a solar cell, the passivating properties are determined by the silicon oxide surface of the tunnel oxide layer. Also, the passivation of dangling bonds of the silicon substrate surface by hydrogen atoms plays a key role.

In one embodiment where the rear surface of the p-type IBC solar cell has alternating structure of n-type polysilicon emitter regions and base region, a dielectric with a negative surface charge, like Al₂O₃ (or a stack comprising Al₂O₃ layer and a-SiNₓ:H layer), can be deposited. Then the presence of the dielectric layer causes the desired accumulation at the base region surface, whereas the tendency towards depletion is not detrimental since, first of all, the doping concentration in n-type polysilicon is rather high and, secondly, the tendency towards depletion takes place at a distance of typically 10-20 nm and therefore does not affect the surface recombination at the tunnel oxide since the polysilicon layer is typically one order of magnitude thicker. In the case of n-type polysilicon, the important function of the dielectric layer is to provide hydrogen that will migrate during an elevated temperature step (usually taking place during firing of the contacts of the solar cell) towards the tunnel oxide and thereby strongly reduces the surface recombination.

In another embodiment the solar cell's rear surface has an interdigitating electrode pattern comprising alternating areas of n-type polysilicon and intrinsic polysilicon. This can typically be made by subsequently depositing the tunnel oxide and the intrinsic polysilicon layer. Thereafter a diffusion barrier pattern is applied and a diffusion of phosphorous atoms into the wafer surface takes place, e.g. by POCl₃ diffusion or by ion implant. This is then followed by removal of the diffusion barrier. In this embodiment the surface passivation is at the tunnel oxide over the full area. The hydrogenation of the tunnel oxide where the hydrogen atoms will be located at the dangling bonds of the silicon wafer surface is resulting in a very high degree of surface passivation. Since a polysilicon layer, of about 200 nm, is covering the tunnel oxide and the surface charge of the dielectric only affects carrier concentration levels to 10-20 nm at the outer polysilicon surface, the sign of the surface charge is not relevant anymore. The only role of the dielectric is for both the intrinsic and the n-type polysilicon to provide hydrogen. In this embodiment therefore the choice of the dielectric layer type is free. This means the dielectric layer can for example be Al₂O₃, a-SiNₓ:H or a stack of these dielectric layers.

The present invention also relates to a solar panel or photovoltaic module comprising one or more of solar cells as described above.

According to an aspect, the invention relates to a method for manufacturing a back-contacted solar cell based on a silicon substrate of p-type conductivity having a front surface for receiving radiation and a rear surface; the method comprising: providing on the rear surface a layer stack of a tunnel oxide layer and a doped polysilicon layer of n-type conductivity, the tunnel oxide layer being arranged between the rear surface and the doped polysilicon layer; patterning the layer stack to have gaps in the layer stack; arranging an Al-Si alloyed contact within each of the gaps, in electrical contact with a base layer of the substrate, and
arranging one or more Ag contacts or transition metal contacts on the doped polysilicon layer of the patterned layer stack and in electrical contact with said doped polysilicon layer.

According to an embodiment, the method includes that the patterning of the layer stack with gaps in the layer stack comprises the deposition or creation of a cover layer comprising a SiO₂ layer and/or a SiNₓ layer and patterning the cover layer by creating openings in the cover layer by means of a local removal of said SiO₂ layer and/or SiNₓ layer(s) by a laser beam.

According to a further embodiment, the method as described above comprises: removing the patterned cover layer to expose the doped polysilicon layer; depositing on the rear surface, over the gaps and the exposed patterned doped polysilicon layer, a dielectric layer, and creating openings in the dielectric layer at location of the gaps by means of a laser beam.

Also, the invention relates to a method for manufacturing a back-contacted solar cell based on a silicon substrate of p-type conductivity having a front surface for receiving radiation and a rear surface; the method comprising:
providing on the rear surface a layer stack of a tunnel oxide layer and an intrinsic polysilicon layer, the tunnel oxide layer being arranged between the rear surface and the intrinsic polysilicon layer; covering the layer stack with a cover layer comprising a SiO₂ layer and/or SiNₓ layer and creating a pattern of sintered SiO₂ layer and/or SiNₓ layer areas in the cover layer; removing the SiO₂ layer and/or SiNₓ layer areas that were not sintered; exposing the intrinsic polysilicon layer not covered by the pattern of sintered SiO₂ and/or SiNₓ layer(s) areas to an n-type dopant species, so as to create a pattern of n-type doped polysilicon layer areas where not covered by the sintered SiO₂ and/or SiNₓ layer(s); removing the patterned sintered SiO₂ and/or SiNₓ layer(s) areas so as to expose one or more areas of intrinsic polysilicon; arranging Al-Si alloyed contacts on said one or more areas of intrinsic polysilicon, each in electrical contact with the respective area of intrinsic polysilicon, and creating Ag contacts or transition metal contacts on one or more of the patterned n-type doped polysilicon layer areas and in electrical contact with said patterned n-type doped polysilicon layer areas.

According to an embodiment, the method comprises that the pattern of sintered SiO₂ layer and/or SiNₓ layer areas is created by using a laser beam as local heat source for sintering.

According to an embodiment, the method as described above further comprises: after said removal of the patterned sintered SiO₂ and/or SiNₓ layer(s) areas, depositing a dielectric layer over the areas of intrinsic polysilicon and the areas of n-type doped polysilicon, and for one or more areas of intrinsic polysilicon, creating a gap or opening at a location in the dielectric layer overlaying the area of intrinsic polysilicon; in which the gap or opening in the dielectric layer overlaying the area of intrinsic polysilicon is created by using a laser beam.

Advantageous embodiments are further defined by the dependent claims.

### Brief description of the drawings

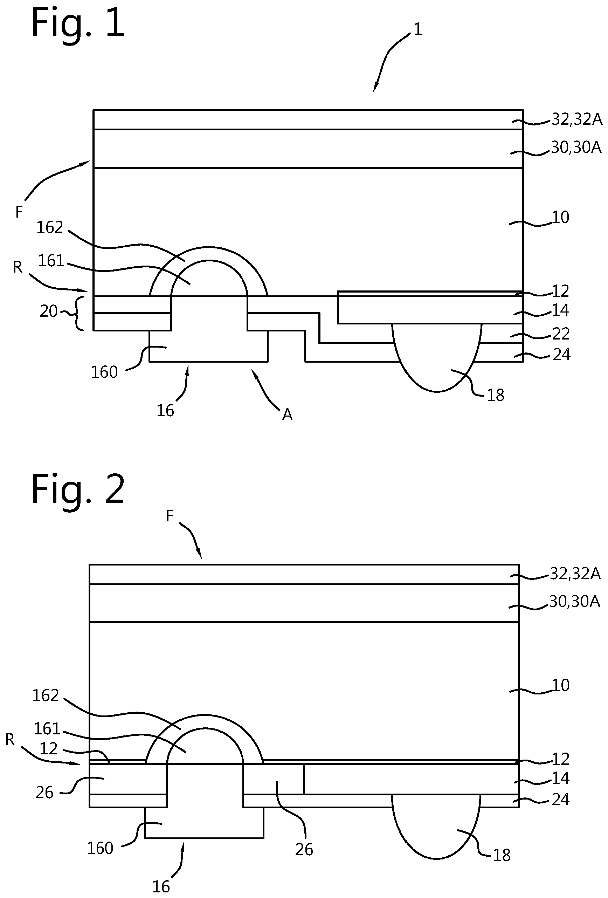

Embodiments of the present invention will be described in more detail hereinafter, by way of example only, with reference to the accompanying drawings which are schematic in nature and therefore not necessarily drawn to scale. Furthermore, corresponding reference signs in the drawings relate to corresponding or substantially similar elements.
In the drawings, Figure 1 schematically shows a cross-section of a solar cell in accordance with an embodiment of the present invention;
Figure 2 schematically shows a cross-section of a solar cell according to an present invention;
Figure 3 schematically shows a cross-section of a solar cell according to an embodiment of the present invention;
Figure 4 schematically shows a plane view of a rear surface of a solar cell according to an embodiment of the present invention;
Figure 5 schematically shows a cross-section of the solar cell of Figure 4;
Figure 6 schematically shows a plane view of a rear surface of a solar cell in accordance with an embodiment of the present invention;
Figure 7 schematically shows a plane view of a rear surface of a solar cell according to an embodiment of the present invention;
Figure 8 shows a cross-section of a solar panel comprising at least one solar cell according to an embodiment of the invention;
Figure 9 shows a cross-section of a solar cell during various stages of a method according to an embodiment, and
Figure 10 shows a cross-section of a solar cell during various stages of a method according to an embodiment.

### Description of embodiments

The solar cell of the present invention is based on a p-type semiconductor substrate with positive and negative polarity contacts arranged on the rear surface of the substrate. The positive contacts directly connect to the p-type base layer of the substrate, while the negative contacts are connected to n-type doped areas on the rear surface. Typically, the positive contacts are embodied as metal-alloy contacts, the negative contacts are embodied as metal or metallic contacts.

Figure 1 schematically shows a cross-section of a solar cell in accordance with an embodiment of the present invention.

According to an embodiment of the invention, a solar cell 1 comprises a silicon substrate 10 of p-type conductivity. For example, the silicon substrate is doped with Boron as dopant species.

The silicon substrate 10 has a front surface F and a rear surface R.

On the rear surface R, a stack of a tunnel oxide layer 12 and a doped poly-silicon layer 14 is arranged. The layer stack 12, 14 is patterned with gaps A to the surface of the silicon substrate. The tunnel oxide layer 12 consists typically of silicon dioxide and typically has a thickness of about 2 nanometer or less.

The patterned doped poly-silicon layer 14 has an n-type conductivity, opposite to the p-type conductivity of the silicon substrate. The thickness of the n-type patterned poly-silicon layer is between about 10 and about 300 nm.

Within the pattern of the patterned n-type doped poly-silicon layer gaps A are present. In the gaps A, a contact 16 of a first conductivity type is positioned that connects to the silicon substrate 10, i.e., the base of the solar cell. In this embodiment, the contact of first conductivity type is a metal-alloy contact, typically an Al-Si contact. Optionally this contact comprises Boron. Such an Al-Si contact consists in general of a layered structure comprising an Al head 160, an Al-Si alloy layer 161 and an Al doped BSF region 162. Optionally, layers 160, 161 and 162 comprise Boron. The BSF region 162 typically is in contact with the silicon matrix of the substrate and envelopes the Al-Si alloy layer 161. The Al head 160 is positioned on top of the Al-Si alloy layer at the rear surface R and extending therefrom. The lateral size of an Al-Si contact at the substrate level is smaller than the lateral size of a gap A to avoid contact with the bordering region of n-type doped polysilicon.

Contacts 18 of the second conductivity type, opposite to the first conductivity type, are arranged on and in electrical contact with the patterned n-type doped poly-silicon layer 14. According to the invention, the contacts 18 of the second conductivity type are embodied as metal contacts, in an embodiment Ag contacts or alternatively transition metal (e.g., Ni-Cu plated, potentially by Light Induced Plating) contacts. The lateral size of an Ag contact 18 is smaller than the lateral size of the patch of the patterned n-type doped poly-silicon on which the Ag contact is positioned.

The patterned n-type doped poly-silicon layer 14 and the openings A are covered by a hydrogenated dielectric layer 20. Such hydrogenated dielectric layer 20 improves the passivation of the rear surface, i.e., the interface between the tunnel oxide and the surface of the silicon substrate 10, by providing hydrogen to mask electrically active faults at the rear surface R, (e.g., dangling bonds at the silicon surface). The hydrogenated dielectric layer 20 can comprise a layer of hydrogenated silicon nitride SiNₓ:H 24, a layer of alumina (Al₂O₃) 22, or a dielectric layer stack of these layers 22, 24. In such a dielectric layer stack, the alumina layer 22 is positioned in-between the rear surface of the substrate and the SiNₓ:H layer 24, since the SiNₓ:H layer may have a positive surface charge.

Both the Al-Si contacts 16 and the Ag contacts 18 extend through the hydrogenated dielectric layer(s) to be in electrical contact with the base of the silicon substrate 10 and the patterned n-type doped poly-silicon layer 14, respectively.

In an embodiment, the hydrogenated dielectric layer is configured to have a negative surface charge. Such negative surface charge influences the distribution of minority and majority charge carriers in the silicon substrate which as explained in the introductory part beneficially provides a reduction of the recombination effect.

In an embodiment, the front surface F which is to receive radiation is covered by an Al₂O₃ layer 30, bordering the silicon substrate 10 of p-type conductivity, and a SiNₓ:H layer 32 on top of the Al₂O₃ layer.

In another embodiment, the front surface F which is to receive radiation is covered by an intrinsic poly-silicon layer 30A and an anti-reflecting coating layer 32A, for example silicon nitride. Since intrinsic poly-silicon is known to parasitically absorb blue light, a solar cell with such an intrinsic poly-silicon layer 30A could be used as a bottom solar cell in a tandem device where the bottom cell mainly harvests Near InfraRed light and the parasitic absorption of i-poly is then relatively low.

In case the front surface F is configured with only an anti-reflecting coating, the solar cell 1 will suffer less from parasitic blue light absorption

Figure 2 schematically shows a cross-section of a solar cell 2 according to an embodiment of the present invention.

The solar cell 2 according to this embodiment comprises a silicon substrate 10 of p-type conductivity.

On the rear surface R, a tunnel oxide layer 12 is arranged. On the tunnel oxide layer 12, a patterned n-type doped poly-silicon layer 14 is arranged.

Within the pattern of the patterned n-type doped poly-silicon layer, regions of intrinsic poly-silicon 26 are present that border on the n-type doped poly-silicon 14. In this embodiment, the tunnel oxide layer 12 is also present between the intrinsic polysilicon 26 and the rear surface R of the silicon substrate.

In the intrinsic poly-silicon region 26, a metal-alloy contact 16; 160,161,162 of a first conductivity type, typically an Al-Si contact, is positioned that connects to the silicon substrate 10, i.e., the base of the solar cell. The lateral size of an Al-Si contact is smaller than the lateral size of the intrinsic poly-silicon region 26.

Metal contacts 18 of the second conductivity type such as Ag contacts are arranged on and in electrical contact with the patterned n-type doped poly-silicon layer 14, as described above with reference to figure 1.

In this embodiment of the solar cell 2, the patterned n-type doped poly-silicon layer 14 and the intrinsic poly-silicon regions 26 are covered by a layer of hydrogenated silicon nitride SiNₓ:H24 which beneficially provides hydrogen for passivation of the rear surface.

Both the Al-Si contacts 16; 160,161,162 and the Ag contacts 18 extend through the hydrogenated dielectric layer(s) to be in electrical contact with the base of the silicon substrate 10 and the patterned n-type doped poly-silicon layer 14, respectively.

Figure 3 schematically shows a cross-section of a solar cell 3 according to an embodiment of the present invention.

The solar cell shown in figure 3 may be regarded as a variant of the solar cell 2 as described above with reference to figure 2.

On the rear surface R, a tunnel oxide layer 12 is arranged. On the tunnel oxide layer 12, a patterned n-type doped poly-silicon layer 14 is arranged.

Within the pattern of the patterned n-type doped poly-silicon layer, regions of intrinsic poly-silicon 26 are present that border on the n-type doped poly-silicon 14. The tunnel oxide layer 12 is also present between the intrinsic polysilicon 26 and the rear surface R of the silicon substrate.

The Ag contact 18 is positioned as shown in figure 2 on the patterned n-type doped poly-silicon 14.

In the region of intrinsic poly-silicon 26, the Al-Si contact 16; 160,161,162 is arranged in electrical contact with the base layer of the silicon substrate 10.

In this embodiment of the solar cell, the intrinsic poly-silicon and the n-type doped poly-silicon are covered with an alumina layer 22 that functions as hydrogenated dielectric layer that provides hydrogen for surface passivation at the tunnel oxide.

The Al-Si contact 16; 160,161,162 is located between flanking bounding elements 28 that consist of a material characterized as an inert material with respect to the alumina dielectric, aluminum and Al-Si alloy. The bounding elements 28 are arranged on the stack of alumina 22 and intrinsic polysilicon 26 which shows to be a stable configuration during the heat treatment to form the Al-Si contacts 16.

In an embodiment, the bounding elements material comprises aluminium-oxide particles. Also, the bounding elements material may comprise a material based on aluminum oxide or aluminium nitride.

The bounding elements are configured to prevent poor Al-BSF formation at the edges of the Al. This reduces contact recombination. This is in particular important if the Al-paste is a firing-through paste with etchant particles, e.g. a glass frit.

Since the material of the bounding elements does not react with the dielectric layer or the silicon substrate at the annealing temperature, the bounding elements act as an inert template during the anneal step. Typically, the anneal step is done between about 660°C and about 800 °C.

In addition, as the aperture (i.e., the width between the bounding elements) determines the surface area where Al reacts with Si, the bounding elements do not require a high aspect ratio and may have a rounded cross-section or sloped side walls like a mound or embankment. The bounding elements can be printed in a similar manner as aluminum based paste, e.g. by screen printing.

Figure 4 schematically shows a plane view of a rear surface of a solar cell in accordance with the embodiment of the solar cell 2 shown in figure 2. On the rear surface R, the Al-Si contacts 16;160,161,162 and Ag contacts 18 are laid out as interdigitating electrodes. The intrinsic poly-silicon layer 26 and the n-type doped poly-silicon layer 14 are laid-out in corresponding interdigitating patterns.

In the intrinsic poly-silicon layer 26 an elongated opening 34 to the silicon substrate has been created by a laser scribe or by printing an etching paste. The Al-Si contact 16; 160,161,162 fills the elongated opening 34 and is in electrical contact with the underlying silicon substrate as shown in Figure 2.

On the intrinsic poly-silicon layer 26 the Al head portion 160 of the Al-Si contact extends beyond the boundaries of the laser scribed elongated opening 34 in both transverse and longitudinal directions Y; X.

Both the Ag contact interdigitating electrode 18 and the Al-Si contact interdigitating electrode 16 are each connected to respective busbar 118; 116 of n-type and p-type polarity, that run in the transverse direction Y perpendicular with the longitudinal direction of the interdigitating electrodes 18;16.

According to the invention, both busbars 116, 118 consist of Ag (or Ag alloy). However, the busbars connecting the Al-Si interdigitating electrode can also be made in a similar way as the Al fingers. During manufacturing, the Ag busbars are formed simultaneous with the Ag contacts i.e., the Ag interdigitating electrodes. The Ag busbar for connecting the Al-Si contact (the Al-Si interdigitating electrode) overlaps 216 with a proximal end of the Al-Si interdigitating electrode 16 to obtain an electrical contact. Usually, busbars 116, 118 are provided with Ag interconnection pads.

It is noted that the layout of the interdigitating electrodes 16, 18 and busbars 116, 118 are similar for the solar cells described with reference to figure 1 and figure 3, respectively.

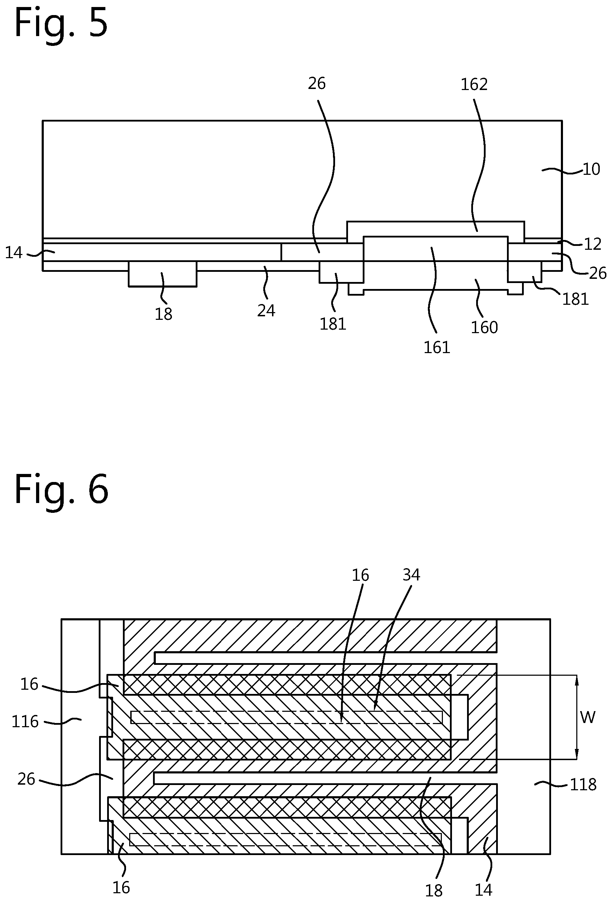

Figure 5 schematically shows a cross-section of a solar cell according to an embodiment of the invention. In this embodiment, the Al-Si contact 16, in particular the Al head 160, is flanked by Ag sub-contacts 181, 182 that creates an electrical contact between the Al head 160 and the top of the intrinsic poly-silicon layer 26, which function as interconnecting pad for solder and electrically conductive adhesive (ECA). As shown in figure 4, Ag busbars are created on both n-type doped poly-silicon 14 and intrinsic poly-silicon 26. This layout allows to use a two-step print of Ag in one step and Al in the other step to create interdigitating electrodes, interconnecting pads and busbars. In the one-step Ag paste print case the Ag paste is firing-through paste that penetrates into the polysilicon. Since the intrinsic poly is not conductive, this will not lead to shunts.

Figure 6 schematically shows a plane view of a rear surface of a solar cell in accordance with an embodiment of the present invention. The layout of the interdigitating electrodes on the rear surface is similar as described above with reference to figure 4. In the embodiment of the solar cell shown in figure 6, the width W of the Al head 160 of the Al-Si contact 16 is larger than the width of the elongated intrinsic poly-silicon 26 surrounding the elongated opening 34 to the silicon substrate. The Al head 160 is configured to overlap a portion of the neighboring n-type doped poly-silicon layer 14.

As it will be appreciated that Al is the limiting factor for the conduction of the metallization (in comparison with Ag). By using a wider Al-Si contact a lower resistance is obtained. Also, by overlapping the n-type doped poly-silicon (the other polarity) the lateral conductance can be improved. Moreover, by varying the Al paste width the alloying process can be tuned. In this way the Al layer size, the alloy layer size and the BSF thickness (i.e., the formation of the layered stack of Al head 160, Al-Si layer 161 and Al-based BSF region 162 and their respective thickness within the Al-Si contact 16) can be tuned for optimal performance.

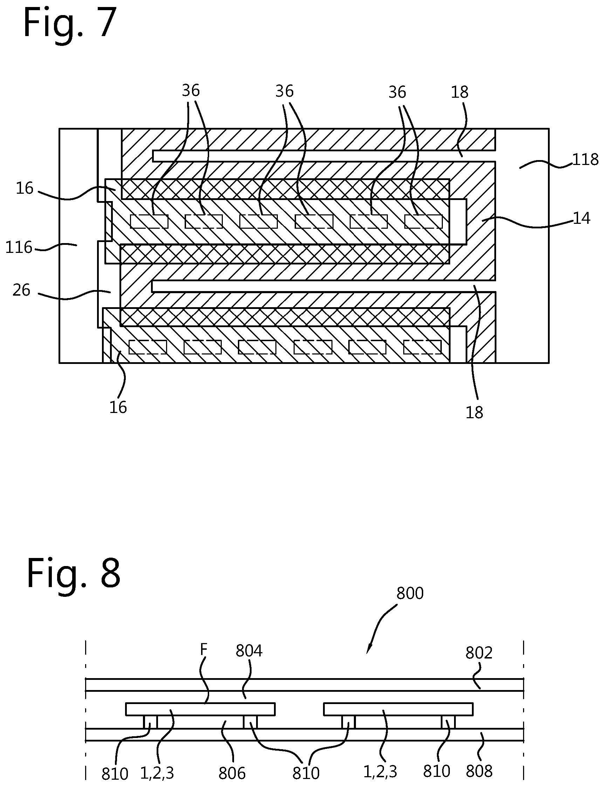

Figure 7 schematically shows a plane view of a rear surface of a solar cell according to an embodiment of the present invention. In this embodiment, the Al-Si interdigitating electrode 16 is provided with a series of intermittent elongated openings 36 in the intrinsic poly-silicon 26 within the length of the electrode. In comparison to the single elongated opening 34 as shown in figure 4 and figure 6 the series of intermittent openings has a shorter contact length with the underlying silicon substrate 10. As a result, recombination in the contact can beneficially be reduced.

As shown here, the layout of intermittent openings 36 can be combined with an Al head layer 160 partially overlapping the neighboring n-type doped poly-silicon 14 to tune performance.

Figure 8 shows a cross-section of a solar panel comprising at least one solar cell according to an embodiment of the invention.

The invention also relates to a solar panel 800 or photovoltaic module that comprises one or more back-contacted solar cells 1;2;3 as described above with reference to the figures 1 - 7.

The solar panel 800 further comprises a transparent top-plate 802, a top encapsulant 804, a bottom encapsulant 806 and a back sheet 808.

The one or more solar cells 1;2;3 are arranged on the backsheet 808, that is provided with a conductor pattern (not shown) to which the busbars 116, 118 that connect to the Al-Si interdigitating electrodes 16 and the Ag interdigitating electrodes, respectively are electrically contacted by solder or conductive adhesive 810. The bottom encapsulant layer 806 is arranged in-between the rear surface R of the one or more solar cells and the back-sheet with contact openings at the locations where the busbars 116; 118 connect to the back-sheet 808.

On top of the solar cells, above the front surfaces F thereof, the top encapsulant 804 is arranged, in-between the solar cells and the top transparent plate 802.

It is noted that the front surface and/or the rear surface R may have a texture of pyramidal shapes.

Also it is noted that the silicon nitride layer 24 at the rear surface R has a thickness that may be tuned for reflection of radiation that has reached the rear surface R. In particular the tuning of the thickness can be done with respect to a minimal wavelength of the radiation. In an embodiment, the minimal wavelength may be about 900 nm. The thickness may be at least about 80 nm, or about 150 nm or preferably about 200 nm.

The solar cell according to the invention can be created by various methods of manufacturing. Below these methods are described.

### Nomenclature

FT=firing-through
NFT = non firing-through
LCO=Local Contact Opening
PGR= POCl3 Glass Removal
SSE=Single Side Etch

The p-type interdigitate back contact (IBC) solar cell is manufactured on boron doped p- type silicon wafer. It has the emitter at rear surface R that does not face to the sunlight and may have or may not have a Front Surface Field (FSF) on the front surface of the silicon substrate. Preferably, the FSF is absent since this saves costly processing steps (e.g. BBr3 diffusion) and moreover, in general, an FSF-free top surface has a lower surface recombination current density. In addition, the high-temperature Boron diffusion step can have detrimental effect on the quality of the base material. Since p-type wafers from an ingot with a resistivity range of 1-3 Ω·cm are standard, an FSF is not really needed to have sufficient conduction in the base. The front Si surface is passivated by a dielectric layer or a stack layer. At the rear surface R, alternating emitter/base-regions are formed by different patterning techniques. A p-type IBC cell with three different types of rear architectures will be described below. These are:
I. A rear surface where diffused emitter regions alternate with base regions, where the entire surface is covered with a dielectric layer or a stack of layers with a negative surface charge.
II. A rear surface where n-type polysilicon emitter regions alternate with base regions, where the entire surface is covered with a, hydrogen-providing, dielectric layer or stack of layers with a negative surface charge.
III. A rear surface where n-type polysilicon emitter regions alternate with intrinsic polysilicon regions, where the entire surface is covered with a, hydrogen-providing, dielectric layer or stack of layers with an arbitrary surface charge.

The solar cell manufacturing process consists of the following steps:
1. Preparing the p-type wafer;
2. Creating a patterned emitter;
3. Applying the front-surface passivation;
4. Applying the rear-surface passivation;
5. Opening of the dielectric;
6. Applying metallization.

These process steps are elaborated below.

### 1. Preparing the p-type wafer (table 1)

**Table 1 Process steps for preparing monocrystalline and multi-crystalline wafers**

| | |
|---|---|
| *Mono-crystalline wafer (e.g. Czochralski (Cz) )* | *Multi-crystalline wafer* |
| *Optional pre-clean in (acidic) wet chemical solution* | *Optional pre-clean in (acidic) wet chemical solution* |
| *Optional saw-damage removal* | *Optional saw-damage removal* |
| *Random pyramid etch, e.g. by wet chemical alkaline (KOH) etch at elevated temperature.* | *Texturing step suitable for mc-Si wafers, like acidic texturing, ISO texture, Reactive Ion Etching, dry etching, Metal-assisted wet chemical etching, alkaline etch and combinations.* |
| *Optional acidic wet chemical etch step to round the pyramid tips and valleys* | *Optional alkaline or acidic etch to remove damage of the previous step* |
| *Optional single sided etch (SSE) step to polish the rear surface* | *Optional SSE step to polish the rear surface* |
| *Optional step to remove micro-roughness at the surface, e.g. by subsequent oxidation (by e.g. HNO3) followed by a (buffered ) HF wet chemical step.* | *Optional step to remove micro-roughness at the surface, e.g. by subsequent oxidation (by e.g. HNO3) followed by* a *(buffered ) HF wet chemical step.* |

### 2. Creating a patterned emitter (table 2).

**Table 2 Rear-surface area type-I (alternating bare base region, with classically diffused emitter region)**

| *Textured wafer* | *Textured wafer* | *Textured wafer* | *Textured wafer* | *Textured wafer* |
|---|---|---|---|---|
| *Optional HF-dip* | *Optional HF-dip* | *Optional HF-dip* | *Optional HF-dip* | *Optional HF-dip* |
| | | *Print diffusion barrier rear* | *Print diffusion barrier* | *Print dopant paste* |
| *POCl3 diffusion PGR SSE front* | *POCl3 diffusion PGR* | *POCl3 diffusion PGR SSE front* | *Ion implant rear surface Anneal Remove barrier* | *Thermal step* |
| *Print etch paste Cure Remove etch paste* | *Print etch barrier on emitter region (Acidic) etch Etch-barrier removal (e.g. diluted KOH and ultrasonic bath)* | | | *PGR and (wet chemical clean)* |

For rear surface type II and III, a polysilicon layer of typically 10-300 nm is applied. Prior to the polysilicon deposition a very thin (e.g. 0.5-2nm) silicon dioxide layer is created on the silicon surface. This can be realized by in-situ deposition in a Low Pressure Chemical Vapor Deposition (LPCVD) system or in a Plasma Enhanced Vapor Deposition (PECVD) system, or by ex-situ chemical oxidation (such as NAOS, RCA, H₂O₂, etc.).

On top of the oxide layer an intrinsic polysilicon layer or an n-type, in situ doped, polysilicon with a thickness of typically 10 - 300nm is deposited by LPCVD or by PECVD. In fact, the PECVD deposition mostly leads to deposition of amorphous silicon (a-Si), which can be converted into polysilicon by an elevated temperature step (anneal).

**Table 3 Rear-side type II ( alternating bare base region, with n-type polysilicon emitter)**

| ***Textured wafer with tunnel-oxide & intrinsic-polysilicon*** | ***Textured wafer with tunnel-oxide & intrinsic-polysilicon*** | ***Textured wafer with tunnel-oxide & in-situ doped n-type polysilicon*** | ***Textured wafer with tunnel-oxide & in-situ doped n-type polysilicon*** |
|---|---|---|---|
| *Optional HF-dip* | *Optional HF-dip* | *Optional HF-dip* | *Optional HF-dip* |
| *POCl3 diffusion PGR SSE front (optional)* | *POCl3 diffusion PGR* | *SSE front (optional)* | |
| *Print etching paste Cure Remove etching paste* | *Print etch barrier on emitter region Wet chemical (acidic) etch Etch-barrier removal* | *Print etch paste Cure Remove etch paste* | *Print etch barrier on emitter region Wet chemical (acidic) etch Etch-barrier removal* |
| *SSE front (optional)* | | *SSE front (optional)* | |

**Table 4 Rear-side type III (alternating intrinsic-polysilicon with n-type polysilicon regions)**

| ***Textured wafer with tunnel-oxide & intrinsic-poly*** | ***Textured wafer with tunnel-oxide & intrinsic-poly*** | ***Textured wafer with tunnel-oxide & intrinsic-poly*** | ***Textured wafer with tunnel-oxide & intrinsic-poly*** |
|---|---|---|---|
| *HF-dip* | *HF-dip* | *HF-dip* | *HF-dip* |
| | *Print diffusion barrier rear* | *Print diffusion barrier* | *Print dopant paste* |
| *POCl3 diffusion PGR* | *POCl3 diffusion PGR SSE front* | *Ion implant rear Anneal Remove barrier* | *Thermal step* |
| *Print etch barrier on targeted emitter region Acidic etch Etch-barrier removal* | | | |

For a special embodiment of type II and III solar cells, the intrinsic polysilicon layer on the front side can deliberately be kept. An intrinsic poly silicon layer on the front side can be obtained if the ion implant takes place on the rear surface R or if a temporary diffusion barrier (e.g. SiO₂ or SiNₓ) is applied on the front surface F and after POCl₃ processing is removed. This embodiment can have a very low front-surface recombination due to the good passivating properties of the oxide-intrinsic poly stack. However the intrinsic polysilicon layer will parasitically absorb blue light. Because of this, this solar cell type is targeted as bottom solar cell in a tandem device.

### 3. Applying the front-surface passivation

For all types I, II, III a (wet) chemical clean step can be applied prior to front coating deposition, which could be RCA-1, RCA-2, HNO₃, (buffered) HF, HCl and different combinations and different sequences.

Front coatings can be Al₂O₃, or a stack of Al₂O₃-SiNₓ or SiNₓ. The preferred coating is the stack of Al₂O₃-SiNₓ since this is proven as passivating layer on the rear surface of PERC solar cells and the layers of the stack can be optimized for antireflection purposes as well. Typically a stack of 6nm Al₂O₃ and 80 nm SiNₓ could work for this purpose.

### 4. Applying the rear surface passivation

**Table 5.**

| Type-I | Type-II | Type-III |
|---|---|---|
| Deposition of a hydrogen-providing dielectric layer or a stack of dielectric layers with a negative surface charge, like | Deposition of a hydrogen-providing dielectric layer or a stack of dielectric layers with a negative surface charge, like | Deposition of a hydrogen-providing dielectric layer or a stack of dielectric layers with an arbitrary surface charge, like |
| Al₂O₃ or Al₂O₃-SiNₓ | Al₂O₃ or Al₂O₃-SiNₓ | |
| | | Al₂O₃ or Al₂O₃-SiNₓ or SiNₓ |

It should be noted that the front dielectric layers could be co-deposited with the rear dielectric layers. For instance, for all types (I, II and III) first double-sided Al₂O₃ followed by double-sided SiNₓ could be applied. Deposition systems in which half-fabricates are levitated and float through the deposition chamber might be a useful for this purpose. It should be noted that, unlike single-side deposition where wrap-around of the deposition can be undesired, the double-sided deposition has more forgiving process conditions.

The rear surface will be opened at the base regions by laser ablation or by printing a chemical etch paste. This is followed by a (wet) chemical clean to remove laser damage and dielectric coating flakes.

Optionally the dielectric is opened in a similar way at the emitter regions, which can later on be used for the contacting of NFT Ag-paste.

### 5. Opening of the dielectric

Openings in the dielectric layer at the base regions are realized. Per targeted aluminium print area this can be a line shape or a series of smaller lines or dots. Opening can be realized by laser ablation or by selective chemical etching, e.g. by printing an etch paste. These steps can be followed with a chemical clean step. Optionally, local contact openings (LCOs) on the emitter regions can be realized in the same process step. The LCOs can then be used to make a metallic contact to the emitter by (screen)printing of NFT Ag-paste or by (Light Induced) plating. It should be noted that for these types of metallization the metal does not penetrate into the n-type polysilicon emitter or into the classically diffused emitter.

### 6. Applying metallization

The process for the metallization is listed in Table 6. Three metal types are envisaged for (screen) printing: Al-paste, FT Ag-paste and NFT Ag-paste. The latter will not fire through the dielectric layer. For the NFT pastes, two categories can be identified: The first is co-fired with the Al-paste and the FT Ag-paste and the second is separately printed and fired, mostly at lower firing temperatures. The second paste type is often referred to as "floating busbar" paste.

The NFT paste is used to make contact to the Al-paste. Both the NFT Ag paste and the FT paste can be electrically connected to the metal leads that series connect solar cells in the photovoltaic module by solder or by electrically conductive adhesive.

In all cases the Al paste is printed on the rear dielectric layer such that the LCO in the dielectric layer of the base region is fully covered. The Al paste area might also partially overlap with the emitter region.

The BSF is formed by an Aluminum-Silicon alloy process in which the Aluminum of the screen-printed Al-paste dissolves the silicon of the base wafer material and, optionally, the intrinsic polysilicon during heating up above 660°C (i.e. the melting point of aluminum) and where during the cooling down phase Al-doped silicon is rejected from the melt and recrystallizes, also known as epitaxial growth.

Table 6 shows metallization options for the types I, II and III.

**Table 6 Metallization options**

| Type I,II,III | Type I,II,III | Type III | Type I,II,III | Type I,II,III |
|---|---|---|---|---|
| *LCO at base region only* | *LCO at base region only* | *LCO at base region only* | *LCO at base region and emitter region* | *LCO at base region and emitter region* |
| (screen) print FT Ag-paste on emitter regions (fingers & busbars) | (screen) print FT Ag-paste on emitter regions (fingers only) | (screen) print FT Ag-paste on emitter regions (fingers & busbars) and on base regions (busbars only) | | Apply Ni and/or Cu plating on the emitter regions. Light-induced plating is an option. |
| (screen) print NFT Ag-paste on base regions | (screen) print NFT Ag-paste on base region to contact Al and as emitter busbars to contact the FT-Ag paste. | | (screen) print NFT Ag-paste on base region to contact Al and in the LCOs of the emitter regions. | (screen) print NFT Ag-paste on base region to contact Al |
| (screen) print Al-paste at base regions on top of LCOs, partially on top of NFT Ag paste. | (screen) print Al-paste at base regions on top of LCOs, partially on top of NFT Ag paste. | (screen) print Al-paste at base regions on top of LCOs, partially on top of the FT Ag-paste. | (screen) print Al-paste at base regions on top of LCOs, partially on top of NFT Ag paste. | (screen) print Al-paste at base regions on top of LCOs, partially on top of NFT Ag paste. |

After the (screen) print steps, the solar cell 1, 2, 3; I, II, III can undergo a thermal step where the FT Ag-paste penetrates the dielectric layer and contacts the classically diffused emitter, the n-type poly silicon emitter or the intrinsic poly-silicon.

The FT Ag-paste can be selected amongst the pastes used for PERC front-side emitter contacting. Examples of the NFT Ag-paste that are used for PERC solar cells rear surfaces are SOL326, SOL 326S by Heraeus, PV56x by Dupont, BS828B by ENC and GB21 by Gonda.

The BSF is formed by an Aluminum-Silicon alloy process in which aluminum of the screen-printed Al-paste dissolves silicon of the base wafer material and, in case of surface-area type III, the intrinsic polysilicon, during heating up above 660°C and where during the cooling down phase Al-doped silicon is rejected from the melt and recrystallizes, which also denoted by epitaxial growth.

All metal conductive pastes can be sintered by co-firing at a temperature of (typically 700-840°C). Due to application of three different pastes, three print steps are required to complete the metallization of this type of p-IBC solar cell. For type III the option exists to apply two print step, namely FT Ag-paste and Al-paste. In that case the FT Ag-paste also penetrates the intrinsic polysilicon but since this layer does not conduct it will not lead to shunt.

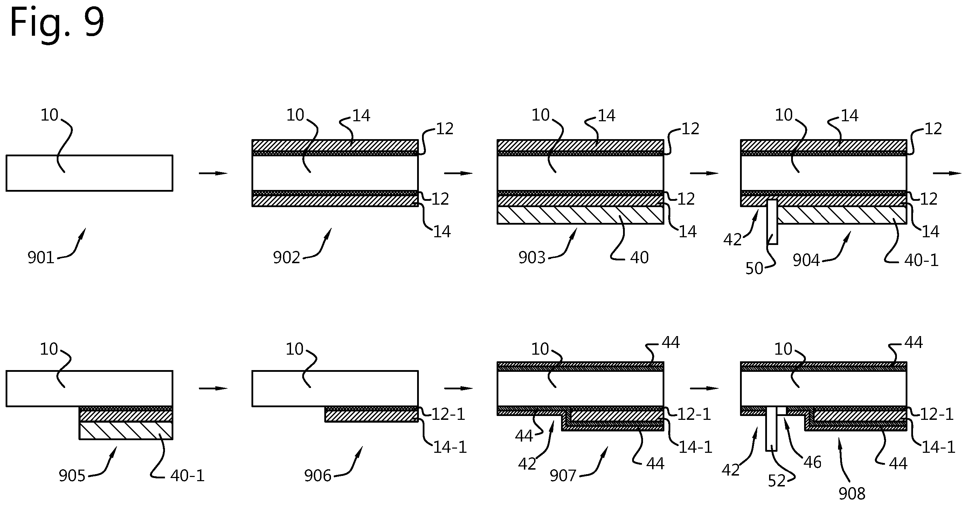

Figure 9 shows a cross-section of a solar cell during various stages of a method according to an embodiment. Here the method is described in relation to the consecutive stages.

In stage 901, a silicon substrate (silicon wafer) 10 is provided as a basis for the solar cell. Typically, the silicon substrate is etched during this stage. The etching step may comprise a polishing etch. Alternatively or additionally the etching step may comprise a first texturing etch followed by a second smoothening etch.

In stage 902, a stack of a thin oxide layer 12 and an n-type polysilicon layer 14 is created on both front and rear surfaces of the silicon substrate. The thin oxide layer is intended as tunnel oxide layer and is arranged in between each of the surfaces of the silicon substrate 10 and the n-type polysilicon layer 14.

In a next stage 903, a SiO₂ layer or SiNₓ layer or a combination thereof, indicated by reference 40, is created as cover layer on the rear side of the silicon substrate (i.e., the side of the substrate where the back contacts are to be formed) on top of the n-type polysilicon layer. Preferably, the SiO₂ layer or SiNₓ layer 40 is created by plasma enhanced chemical vapor deposition PECVD, on the rear side of the substrate 10.

Then in a subsequent stage 904, a laser beam 50 is used for creating a gap 42 or opening 42 in the cover layer 40 on the rear surface. The laser beam 50 is configured to selectively remove the SiO₂ layer and/or SiNₓ layer 40 at predetermined locations on the rear surface. Thus a patterned SiO₂ layer and/or SiNₓ layer 40-1 is obtained in which the gaps or openings 42 expose the underlying n-type polysilicon layer.

Next, in stage 905, the substrate is exposed to an all-sided alkaline etch. The alkaline etch selectively removes the exposed polysilicon layer 14 and thin oxide 12 at the rear surface while using the patterned SiO₂ layer or SiNₓ layer 40-1 as a mask layer. Thus in the gaps or openings 42 in the patterned SiO₂ layer or SiNₓ layer 40-1 the surface of the substrate 10 is now exposed. At the same time, the n-type polysilicon layer 14 and thin oxide layer 12 are removed from the front surface by the alkaline etch. The alkaline etch may comprise a surfactant and depending on its composition and temperature the etch can be isotropic or anisotropic resulting in a (random pyramid) texture.

In stage 906, the alkaline etch is followed by a HF (fluoric acid) etch which now selectively removes the patterned SiO₂ layer or SiNₓ layer 40-1 from the rear surface. A patterned layer stack of thin oxide 12-1 and n-type polysilicon 14-1 remains at the rear surface.

Subsequently, in stage 907, the substrate comprising the patterned layer stack 12-1, 14-1 on the rear surface is exposed to an all-sided deposition of a dielectric layer of either an Al₂O₃ layer 44, or a SiNₓ layer 44 or a stack 44 of Al₂O₃ and SiNₓ layers.

Finally in stage 908, a laser beam 52 is used to remove the Al₂O₃ and/or SiNₓ layers 44 at a location(s) 46 inside the gaps or openings 42 created earlier in stage 904. Thus, at the location(s) an area portion of the silicon substrate is exposed.

At the exposed area portion at the location(s) 46, an Al-Si contact can be formed at a later stage, as described above with reference to Figure 1 for example.

The method relates to providing on the rear surface a layer stack of a tunnel oxide layer and a doped polysilicon layer of n-type conductivity, the tunnel oxide layer being arranged between the rear surface and the doped polysilicon layer; patterning the layer stack to have gaps in the layer stack; arranging an Al-Si alloyed contact within each of the gaps, in electrical contact with a base layer of the substrate, and arranging one or more Ag contacts or transition metal contacts on the doped polysilicon layer of the patterned layer stack and in electrical contact with said doped polysilicon layer.

According to an aspect of the method, the patterning of the layer stack with gaps in the layer stack comprises the deposition or creation of a cover layer comprising a SiO₂ layer and/or a SiNₓ layer and patterning the cover layer by creating openings in the cover layer by means of a local removal of said SiO₂ layer and/or SiNₓ layer(s) by a laser beam.

The SiO₂ and/or SiNₓ layer(s) are sacrificial layers in this exemplary embodiment. The skilled in the art will appreciate the method may be modified in a manner that the patterned SiO₂ and/or SiNₓ layer(s), forming a barrier against alkaline etch, are permanent layers.

In addition, it will be appreciated that the stages as described may be combined with other intermediate processing steps not described here. Such intermediate processing steps may be required for preparation, transportation, intermediate cleaning, native oxide removal, etc.

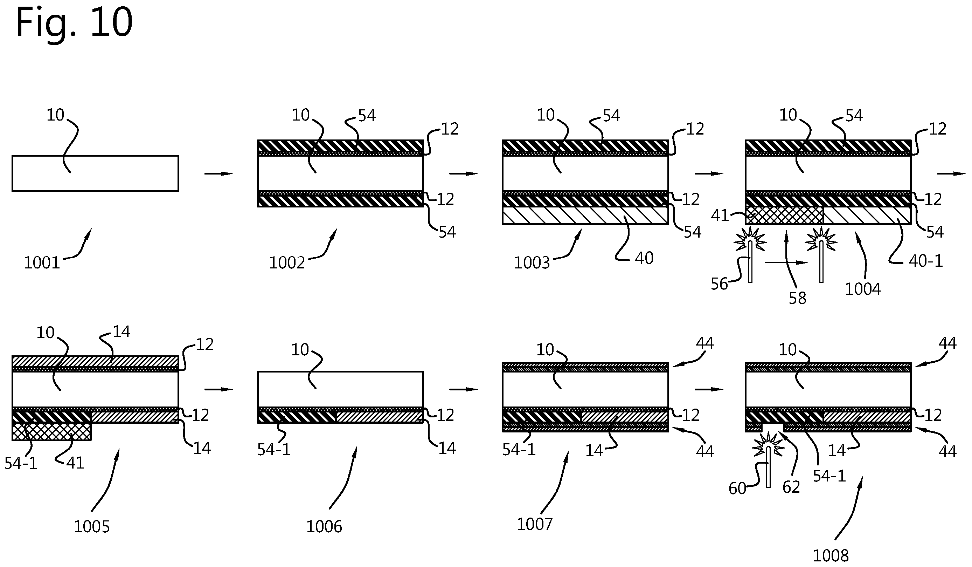

Figure 10 shows a cross-section of a solar cell during various stages 1001 - 1008 of a method according to an embodiment. In this embodiment, a stack of a thin oxide layer 12 and an intrinsic polysilicon layer 54 is applied instead of the stack of a thin oxide layer and an n-type doped polysilicon layer. The term "intrinsic polysilicon" is to be construed here as undoped polysilicon or intentionally undoped polysilicon, i.e., having a base dopant level at least an order of magnitude lower than the n-type dopant level.

Here the embodiment of the method is described in relation to the consecutive stages.

In stage 1001, a silicon substrate (silicon wafer) 10 is provided as a basis for the solar cell. Typically, the silicon substrate is etched during this stage. The etching step may comprise a polishing etch. Alternatively or additionally the etching step may comprise a first texturing etch followed by a second smoothening etch.

In stage 1002, a stack of a thin oxide layer 12 and an intrinsic polysilicon layer 54 is created on both front and rear surfaces of the silicon substrate. The thin oxide layer is intended as tunnel oxide layer and is arranged in between each of the surfaces of the silicon substrate and the intrinsic polysilicon layer.

In a next stage 1003, a SiO₂ layer or SiNₓ layer or a combination thereof indicated by reference 40 is created as cover layer on top of the intrinsic polysilicon layer 54 on the rear side of the silicon substrate 10 (i.e., the side of the substrate where the back contacts are to be formed). Preferably, the SiO₂ layer or SiNₓ layer or combination layer 40 is created by plasma enhanced chemical vapor deposition PECVD, on the rear side of the substrate.

Then in a subsequent stage 1004, a laser beam 56 is used for creating a sintered area 41 in the SiO₂ layer or SiNₓ layer or combination layer 40 on the rear surface. The laser beam is configured to selectively heat the SiO₂ layer or SiNₓ layer or combination layer 40 at predetermined locations 58 on the rear surface, which has the effect that the SiO₂ layer or SiNₓ layer or combination layer 40 is structurally modified in comparison with the portion 40-2 of the SiO₂ layer or SiNₓ layer or combination layer 40 that is not irradiated by the laser beam 56. The structural modification at the predetermined location(s) 58 may involve a densification of the irradiated SiO₂ layer or SiNₓ layer and/or structural phase transition of the layer.

Next, in stage 1005, the substrate is exposed to an all-sided HF etch. The HF etch selectively removes the non-sintered portion 40-2 of the SiO₂ layer and/or SiNₓ layer 40 from the front and rear surfaces.

The sintered polysilicon layer at the rear surface remains and is used as a patterned mask layer. In this manner, the intrinsic polysilicon is exposed on the rear surface in a pattern corresponding with the locations where the non-sintered SiO₂ layer or SiNₓ layer was removed.

After the HF etch process, the substrate is subjected to a n-type doping process which provides diffusion of an n-type dopant into the exposed intrinsic polysilicon to create n-type doped polysilicon 14 at the exposed locations. In an embodiment, the n-type dopant is phosphorous. The doping process can be the well-known POCl₃ process which uses phosphoryl chloride as precursor.

Under the sintered SiO₂ layer or SiNₓ layer area(s) 41 the polysilicon layer remains an intrinsic polysilicon layer 54-1 after stage 1005.

In a next stage 1006, an HF etch is applied to remove the sintered oxide layer and -if present- the Phosphor glass resulting from the POCl₃ process and subsequently a single sided etch on the front surface of the substrate10 is carried out. In this process, as shown in stage 1006, the n-type polysilicon 14 and thin oxide 12 layers remain at the rear surface but are removed from the front surface.

On the rear surface a patterned polysilicon layer remains that comprises areas of intrinsic polysilicon 54-1 and areas of n-type doped polysilicon 14. Between the patterned polysilicon layer 14, 54-1 and the substrate 10 the thin-oxide layer 12 is arranged.

Subsequently, in stage 1007, the substrate 10 comprising the patterned polysilicon layer 14, 54-1 stacked on the thin oxide layer 12 on the rear surface is exposed to an all-sided deposition of a hydrogen providing dielectric coating which can be either an Al₂O₃ layer, or a SiNₓ layer or a stack of Al₂O₃ and SiNₓ layers, indicated by reference 44.

Finally in stage 1008, a laser beam 60 is used to remove/open the Al₂O₃ and/or SiNₓ layers 44 at a location(s) 62 above the intrinsic polysilicon layer 54-1 created earlier in stage 1005. Thus, at the location(s) 62 an area portion of the intrinsic polysilicon 54-1 is exposed. At the exposed area portion, an Al-Si contact (not shown) can be formed at a later stage by depositing aluminium on the intrinsic polysilicon and a subsequent annealing.

In this embodiment, the method relates to providing on the rear surface a layer stack of a tunnel oxide layer and an intrinsic polysilicon layer, the tunnel oxide layer being arranged between the rear surface and the intrinsic polysilicon layer; covering the layer stack with a cover layer comprising a SiO₂ layer and/or SiNₓ layer and creating a pattern of sintered SiO₂ layer and/or SiNₓ layer areas within the cover layer; removing the SiO₂ layer and/or SiNₓ layer areas that were not sintered; exposing the intrinsic polysilicon layer not covered by the pattern of sintered SiO₂ and/or SiNₓ layer(s) areas to an n-type dopant species, so as to create a pattern of n-type doped polysilicon layer areas where not covered by the sintered SiO₂ and/or SiNₓ layer(s); removing the patterned sintered SiO₂ and/or SiNₓ layer(s) areas so as to expose one or more areas of underlying intrinsic polysilicon; arranging Al-Si alloyed contacts on said one or more areas of intrinsic polysilicon, each in electrical contact with the respective area of intrinsic polysilicon, and creating Ag contacts or transition metal contacts on one or more of the patterned n-type doped polysilicon layer areas and in electrical contact with said patterned n-type doped polysilicon layer areas.

According to an embodiment, the method further comprises that the pattern of sintered SiO₂ layer and/or SiNₓ layer areas is created by using a laser beam as local heat source for sintering.

According to an embodiment, the method further comprises, after said removal of the patterned sintered SiO₂ and/or SiNₓ layer(s) areas, a step of depositing a dielectric layer over the areas of intrinsic polysilicon and the areas of n-type doped polysilicon, and for one or more areas of intrinsic polysilicon, creating a gap or opening at a location in the dielectric layer overlaying the area of intrinsic polysilicon, in which the gap or opening in the dielectric layer overlaying the area of intrinsic polysilicon is created by using a laser beam.

In the foregoing description, the invention has been described with reference to specific embodiments thereof. It will, however, be evident that various modifications and changes may be made thereto without departing from the scope of the invention as summarized in the attached claims.

## Claims

1. A back-contacted solar cell (1;2;3;908;1008) based on a silicon substrate (10) of p-type conductivity having a front surface (F) for receiving radiation and a rear surface (R);
in which the rear surface is provided with a tunnel oxide layer (12) and a doped polysilicon layer (14) of n-type conductivity; the tunnel oxide layer and the doped polysilicon layer of n-type conductivity forming a patterned layer stack provided with gaps (A) in the patterned layer stack;
**characterized in that** an Al-Si alloyed contact (16;160,161,162) is arranged within each of the gaps, in electrical contact with a base layer (10) of the substrate, and
one or more Ag contacts or transition metal contacts (18) are arranged on the patterned doped polysilicon layer and in electrical contact with the patterned doped polysilicon layer (14).

2. The solar cell according to claim 1, comprising an intrinsic polysilicon layer (26;54-1) bordering on the patterned doped polysilicon layer (14) of n-type conductivity and covering the rear surface of silicon substrate in the gap, the tunnel oxide additionally being arranged between the intrinsic polysilicon layer and the rear surface of the silicon substrate in the gaps and the Al-Si contacts extending through the intrinsic polysilicon layer (26;54-1) and tunnel oxide layer (12).

3. The solar cell according to claim 1, wherein a hydrogenated dielectric layer (20;22;24) is arranged to cover the gaps and the patterned doped polysilicon layer, with the Al-Si contacts and the Ag contacts or transition metal contacts each extending through the hydrogenated dielectric layer, and optionally, wherein the hydrogenated dielectric layer has a negative surface charge.

4. The solar cell according to claim 3 , wherein the hydrogenated dielectric layer (20;22;24) comprises an Al₂O₃ layer or a stack of a-SiNₓ:H layer and an Al₂O₃ layer, with the Al₂O₃ layer between the a-SiNₓ:H layer and the gaps and the patterned doped polysilicon layer.

5. The solar cell according to claim 2, wherein a hydrogen providing dielectric layer (22;44) is arranged to cover the intrinsic polysilicon layer (26) and the patterned doped polysilicon layer (14), with the Al-Si contacts and the Ag contacts or transition metal contacts each extending through the hydrogen providing dielectric layer, and optionally, wherein the hydrogen providing dielectric layer comprises an a-SiNₓ:H layer, an Al₂O₃ layer or a stack of an a-SiNₓ:H layer and an Al₂O₃ layer.

6. The solar cell according to any one of claims 2 -5, wherein an Ag contact body (18) is bordering the Al-Si contacts (16) on the intrinsic polysilicon layer (26).

7. The solar cell according to claim 3, wherein the Ag is based on firing-through Ag paste material.

8. The solar cell according to claim 7, wherein the Al-Si contacts (16) and the Ag contacts or transition metal contacts (18) are arranged as interdigitating electrodes between a first busbar (118) connecting the Ag contacts or transition metal contacts and a second busbar (116) connecting the Al-Si contacts; the busbars extending along the rear surface in a direction perpendicular to a length of the interdigitating electrodes, and
the Al-Si interdigitating electrode comprises a plurality of individual Al-Si contacts arranged along the length of the interdigitating electrode, the plurality of Al-Si contacts being interconnected by an elongated Al or Al-Si alloy body extending above the plurality of Al-Si contacts.

9. The solar cell according to any one of claims 7-8, wherein a portion of the Al-Si interdigitating electrode (16) laterally extends over a portion of the bordering patterned doped polysilicon layer (14) of n-type conductivity.

10. The solar cell according to claim 2, wherein laser scribed openings are positioned in the dielectric layer above locations of the gaps (A).

11. The solar cell according to any one of claims 3 - 6, wherein laser scribed openings are positioned in the hydrogenated dielectric layer above gaps (A) in which the Al-Si contacts (16) are positioned, and laser scribed openings are positioned in the hydrogenated dielectric layer in which the Ag contacts or transition metal contacts (18) are positioned above the patterned doped polysilicon layer (14) of n-type conductivity, and optionally, wherein the Ag is based on non-firing-through Ag-based paste material.

12. The solar cell according to any one of the preceding claims 1 - 11, further comprising a dielectric layer on the front surface, the dielectric layer configured with a negative surface charge, and optionally, further comprising on the front surface an intrinsic polysilicon layer which is covered by a hydrogen providing dielectric layer.

13. The solar cell according to claim 5, wherein the Al-Si contact is bordered at its edges by bounding elements (28) arranged on the hydrogen providing dielectric layer (22), the bounding elements consisting of a material characterized as an inert material with respect to the hydrogen providing dielectric layer material and to aluminum.

14. A method for manufacturing a back-contacted solar cell (1;2;3;908;1008) based on a silicon substrate (10) of p-type conductivity having a front surface (F) for receiving radiation and a rear surface (R);
the method comprising:
providing on the rear surface a layer stack of a tunnel oxide layer (12) and a doped polysilicon layer (14) of n-type conductivity, the tunnel oxide layer being arranged between the rear surface and the doped polysilicon layer;
patterning the layer stack to have gaps in the layer stack;
**characterized by**
arranging Al-Si alloyed contacts (16; 160,161,162) within each of the gaps, in electrical contact with a base layer of the substrate (10), and
arranging one or more Ag contacts or transition metal contacts (18) on the doped polysilicon layer of the patterned layer stack and in electrical contact with said doped polysilicon layer.

15. The method according to claim 14, wherein the patterning of the layer stack (12,14) with gaps (A) in the layer stack comprises the deposition or creation of a cover layer (40) comprising a SiO₂ layer and/or a SiNₓ layer and patterning the cover layer by creating openings (42) in the cover layer by means of a local removal of said SiO₂ layer and/or SiNₓ layer(s) by a laser beam (50), and optionally, further comprising removing the patterned cover layer (40-1) to expose the doped polysilicon layer (14);
depositing on the rear surface, over the gaps and the exposed patterned doped polysilicon layer, a dielectric layer (44), and
creating openings in the dielectric layer at location (62) of the gaps by means of a laser beam (60).

16. A method for manufacturing a back-contacted solar cell (1008) based on a silicon substrate (10) of p-type conductivity having a front surface (F) for receiving radiation and a rear surface (R); the method comprising:
providing on the rear surface a layer stack of a tunnel oxide layer (12) and an intrinsic polysilicon layer (54), the tunnel oxide layer being arranged between the rear surface and the intrinsic polysilicon layer;
covering the layer stack (12,54) with a cover layer (40) comprising a SiO₂ layer and/or SiNₓ layer and creating a pattern of sintered SiO₂ layer and/or SiNₓ layer areas (41) in the cover layer;
removing the SiO₂ layer and/or SiNₓ layer areas (40-2) that were not sintered;
exposing the intrinsic polysilicon layer (54) not covered by the pattern of sintered SiO₂ and/or SiNₓ layer(s) areas to an n-type dopant species, so as to create a pattern of n-type doped polysilicon layer areas (14) where not covered by the sintered SiO₂ and/or SiNₓ layer(s);
removing the patterned sintered SiO₂ and/or SiNₓ layer(s) areas so as to expose one or more areas of intrinsic polysilicon (54-1);
**characterized by**
arranging Al-Si alloyed contacts on said one or more areas of intrinsic polysilicon, each in electrical contact with the respective area of intrinsic polysilicon, and
creating Ag contacts or transition metal contacts on one or more of the patterned n-type doped polysilicon layer areas and in electrical contact with said patterned n-type doped polysilicon layer areas, and optionally,
wherein the pattern of sintered SiO₂ layer and/or SiNₓ layer areas is created by using a laser beam as local heat source for sintering.

17. The method according to claim 16, further comprising:
after said removal of the patterned sintered SiO₂ and/or SiNₓ layer(s) areas, depositing a dielectric layer (44) over the areas of intrinsic polysilicon (54-1) and the areas of n-type doped polysilicon (14), and
for one or more areas of intrinsic polysilicon, creating a gap or opening at a location in the dielectric layer overlaying the area of intrinsic polysilicon;
wherein the gap or opening in the dielectric layer overlaying the area of intrinsic polysilicon is created by using a laser beam (60).

## Patentansprüche

1. Rückkontaktsolarzelle (1;2;3;908;1008) auf der Basis eines Siliziumsubstrats (10) mit p-Typ-Leitfähigkeit mit einer Vorderseite (F) zum Empfangen von Strahlung und einer Rückseite (R);
wobei die Rückseite mit einer Tunneloxidschicht (12) und einer dotierten Polysiliziumschicht (14) mit n-Typ-Leitfähigkeit versehen ist; wobei die Tunneloxidschicht und die dotierte Polysiliziumschicht mit n-Typ-Leitfähigkeit einen strukturierten Schichtstapel bilden, der mit Zwischenräumen (A) in dem strukturierten Schichtstapel versehen ist; **dadurch gekennzeichnet, dass** ein Al-Si-legierter Kontakt (16; 160, 161, 162) in jedem der Zwischenräume angeordnet ist, in elektrischem Kontakt mit einer Basisschicht (10) des Substrats, und
ein oder mehrere Ag-Kontakte oder Übergangsmetallkontakte (18) auf der strukturierten dotierten Polysiliziumschicht und in elektrischem Kontakt mit der strukturierten dotierten Polysiliziumschicht (14) angeordnet sind.

2. Solarzelle nach Anspruch 1, umfassend eine intrinsische Polysiliziumschicht (26;54-1), die an die strukturierte dotierte Polysiliziumschicht (14) mit n-Typ-Leitfähigkeit angrenzt und die Rückseite des Siliziumsubstrats in dem Zwischenraum bedeckt, wobei das Tunneloxid zusätzlich zwischen der intrinsischen Polysiliziumschicht und der Rückseite des Siliziumsubstrats in den Zwischenräumen angeordnet ist und die Al-Si-Kontakte sich durch die intrinsische Polysiliziumschicht (26; 54-1) und die Tunneloxidschicht (12) erstrecken.

3. Solarzelle nach Anspruch 1, wobei eine hydrierte dielektrische Schicht (20; 22; 24) so angeordnet ist, dass sie die Zwischenräume und die strukturierte dotierte Polysiliziumschicht bedeckt, wobei sich die Al-Si-Kontakte und die Ag-Kontakte oder Übergangsmetallkontakte jeweils durch die hydrierte dielektrische Schicht erstrecken, und wobei die hydrierte dielektrische Schicht optional eine negative Oberflächenladung aufweist.

4. Solarzelle nach Anspruch 3, wobei die hydrierte dielektrische Schicht (20; 22; 24) eine Al₂O₃-Schicht oder einen Stapel aus einer a-SiNₓ:H-Schicht und einer Al₂O₃-Schicht umfasst, wobei sich die Al₂O₃-Schicht zwischen der a-SiNₓ:H-Schicht und den Zwischenräumen und der strukturierten dotierten Polysiliziumschicht befindet.

5. Solarzelle nach Anspruch 2, wobei eine wasserstoffliefernde dielektrische Schicht (22; 44) so angeordnet ist, dass sie die intrinsische Polysiliziumschicht (26) und die strukturierte dotierte Polysiliziumschicht (14) bedeckt, wobei sich die Al-Si-Kontakte und die Ag-Kontakte oder Übergangsmetallkontakte jeweils durch die wasserstoffliefernde dielektrische Schicht erstrecken, und wobei optional die wasserstoffliefernde dielektrische Schicht eine a-SiNₓ:H-Schicht, eine Al₂O₃-Schicht oder einen Stapel aus einer a-SiNₓ:H-Schicht und einer Al₂O₃-Schicht umfasst.

6. Solarzelle nach einem der Ansprüche 2-5, wobei ein Ag-Kontaktkörper (18) an die Al-Si-Kontakte (16) auf der intrinsischen Polysiliziumschicht (26) angrenzt.

7. Solarzelle nach Anspruch 3, wobei das Ag auf einem durchbrennfähigen Ag-Pastenmaterial basiert.

8. Solarzelle nach Anspruch 7, wobei die Al-Si-Kontakte (16) und die Ag-Kontakte oder Übergangsmetallkontakte (18) als interdigitierende Elektroden zwischen einer ersten Sammelschiene (118), die die Ag-Kontakte oder Übergangsmetallkontakte verbindet, und einer zweite Sammelschiene (116), die die Al-Si-Kontakte verbindet, angeordnet sind; wobei sich die Sammelschienen entlang der Rückseite in einer Richtung senkrecht zu einer Länge der interdigitierenden Elektroden erstrecken, und wobei die interdigitierende Al-Si-Elektrode eine Vielzahl einzelner Al-Si-Kontakte umfasst, die entlang der Länge der interdigitierenden Elektrode angeordnet sind, wobei die Vielzahl der Al-Si-Kontakte durch einen länglichen Körper aus Al oder einer Al-Si-Legierung miteinander verbunden sind, der sich oberhalb der Vielzahl der Al-Si-Kontakte erstreckt.

9. Solarzelle nach einem der Ansprüche 7-8, wobei sich ein Teil der Al-Siinterdigitierenden Elektrode (16) seitlich über einen Teil der angrenzenden strukturierten dotierten Polysiliziumschicht (14) mit n-Typ-Leitfähigkeit erstreckt.

10. Solarzelle nach Anspruch 2, wobei lasergeschriebene Öffnungen in der dielektrischen Schicht über den Stellen der Zwischenräume (A) positioniert sind.

11. Solarzelle nach einem der Ansprüche 3-6, wobei lasergeschriebene Öffnungen in der hydrierten dielektrischen Schicht über den Zwischenräumen (A) positioniert sind, in denen die Al-Si-Kontakte (16) positioniert sind, und die lasergeschriebenen Öffnungen in der hydrierten dielektrischen Schicht positioniert sind, in der die Ag-Kontakte oder Übergangsmetallkontakte (18) über der strukturierten dotierten Polysiliziumschicht (14) mit n-Typ-Leitfähigkeit positioniert sind, und optional, wobei das Ag auf nicht durchbrennendem Ag-basiertem Pastenmaterial basiert.

12. Solarzelle nach einem der voranstehenden Ansprüche 1-11, weiter umfassend eine dielektrische Schicht auf der Vorderseite, wobei die dielektrische Schicht mit einer negativen Oberflächenladung konfiguriert ist, und optional weiter umfassend eine intrinsische Polysiliziumschicht auf der Vorderseite, die durch eine wasserstoffliefernde dielektrische Schicht bedeckt ist.

13. Solarzelle nach Anspruch 5, wobei der Al-Si-Kontakt an seinen Kanten durch Begrenzungselemente (28) begrenzt ist, die auf der wasserstoffliefernden dielektrischen Schicht (22) angeordnet sind, wobei die Begrenzungselemente aus einem Material bestehen, das sich als ein inertes Material in Bezug auf das Material der wasserstoffliefernden dielektrischen Schicht und auf Aluminium auszeichnet.

14. Verfahren zur Herstellung einer Rückkontaktsolarzelle (1; 2; 3; 908; 1008) auf der Basis eines Siliziumsubstrats (10) mit p-Typ-Leitfähigkeit, mit einer Vorderseite (F) zum Empfangen von Strahlung und einer Rückseite (R);
wobei das Verfahren Folgendes umfasst:
Bereitstellen eines Schichtstapels einer Tunneloxidschicht (12) und einer dotierten Polysiliziumschicht (14) mit n-Typ-Leitfähigkeit, wobei die Tunneloxidschicht zwischen der Rückseite und der dotierten Polysiliziumschicht angeordnet ist;
Strukturieren des Schichtstapels, so dass er Zwischenräume in dem Schichtstapel aufweist;
**gekennzeichnet durch**
das Anordnen von Al-Si-legierten Kontakten (16; 160, 161, 162) in jedem der Zwischenräume, in elektrischem Kontakt mit einer Basisschicht des Substrats (10), und
das Anordnen eines oder mehrerer Ag-Kontakte oder Übergangsmetallkontakte (18) auf der dotierten Polysiliziumschicht des strukturierten Schichtstapels und in elektrischem Kontakt mit der dotierten Polysiliziumschicht.

15. Verfahren nach Anspruch 14, wobei die Strukturierung des Schichtstapels (12, 14) mit Zwischenräumen (A) in dem Schichtstapel die Abscheidung oder Erzeugung einer Deckschicht (40), die eine SiO₂-Schicht und/oder eine SiNₓ-Schicht umfasst, und die Strukturierung der Deckschicht durch Erzeugen von Öffnungen (42) in der Deckschicht mittels einer lokalen Entfernung der SiO₂-Schicht und/oder der SiNₓ-Schicht(en) durch einen Laserstrahl (50) umfasst, und optional weiter umfassend das Entfernen der strukturierten Deckschicht (40-1), um die dotierte Polysiliziumschicht (14) freizulegen;
Aufbringen einer dielektrischen Schicht (44) auf der Rückseite über den Zwischenräumen und der freiliegenden, strukturierten, dotierten Polysiliziumschicht, und
Erzeugen von Öffnungen in der dielektrischen Schicht an der Stelle (62) der Zwischenräume mittels eines Laserstrahls (60).

16. Verfahren zur Herstellung einer Rückkontaktsolarzelle (1008) auf Basis eines Siliziumsubstrats (10) mit p-Typ-Leitfähigkeit, mit einer Vorderseite (F) zum Empfangen von Strahlung und einer Rückseite (R); wobei das Verfahren Folgendes umfasst:
Bereitstellen eines Schichtstapels einer Tunneloxidschicht (12) und einer intrinsischen Polysiliziumschicht (54) auf der Rückseite, wobei die Tunneloxidschicht zwischen der Rückseite und der intrinsischen Polysiliziumschicht angeordnet ist;
Bedecken des Schichtstapels (12, 54) mit einer Deckschicht (40), die eine SiO₂-Schicht und/oder SiNₓ-Schicht umfasst, und Erzeugen einer Strukturierung aus gesinterten SiO₂-Schicht- und/oder SiNₓ-Schicht-Bereichen (41) in der Deckschicht;
Entfernen der SiO₂-Schicht- und/oder SiNₓ-Schicht-Bereiche (40-2), die nicht gesintert wurden;
Aussetzen der intrinsischen Polysiliziumschicht (54), die nicht von der Strukturierung aus gesinterten SiO₂- und/oder SiNₓ-Schicht-Bereichen bedeckt ist, einer n-Dotierstoffspezies, um eine Strukturierung aus n-dotierten Polysiliziumschicht-Bereichen (14) zu erzeugen, die nicht durch die gesinterte(n) SiO₂- und/oder SiNₓ - Schicht(en) bedeckt sind;
Entfernen der/des strukturierten gesinterten SiO₂- und/oder SiNₓ-Schicht-Bereiche(s), um einen oder mehrere Bereiche aus intrinsischem Polysilizium (54-1) freizulegen;
**gekennzeichnet durch**
das Anordnen von Al-Si-legierten Kontakten auf dem einen oder den mehreren Bereichen aus intrinsischem Polysilizium, jeweils in elektrischem Kontakt mit dem jeweiligen Bereich aus intrinsischem Polysilizium, und
Erzeugen von Ag-Kontakten oder Übergangsmetallkontakten auf einem oder mehreren der strukturierten n-dotierten Polysiliziumschicht-Bereiche und in elektrischem Kontakt mit den strukturierten n-dotierten Polysiliziumschicht-Bereichen, und optional,
wobei die Strukturierung der gesinterten SiO₂-Schicht- und/oder SiNₓ-Schicht-Bereiche durch Verwendung eines Laserstrahls als lokale Wärmequelle zum Sintern erzeugt wird.

17. Verfahren nach Anspruch 16, weiter umfassend:
nach dem Entfernen der/des strukturierten gesinterten SiO₂-Schicht- und/oder SiNₓ-Schicht-Bereiche(s),
Abscheiden einer dielektrischen Schicht (44) über den Bereichen aus intrinsischem Polysilizium (54-1) und den Bereichen aus n-dotiertem Polysilizium (14), und
Erzeugen eines Zwischenraums oder einer Öffnung an einer Stelle in der dielektrischen Schicht, die den Bereich aus intrinsischem Polysilizium überlagert, für einen oder mehrere Bereiche aus intrinsischem Polysilizium,
wobei der Zwischenraum oder die Öffnung in der dielektrischen Schicht, die den Bereich aus intrinsischem Polysilizium überlagert, durch Verwendung eines Laserstrahls (60) erzeugt wird.

## Revendications

1. Cellule solaire à contact arrière (1 ;2 ;3 ;908 ;1008) à base d'un substrat de silicium (10) de conductivité de type p présentant une surface avant (F) pour recevoir un rayonnement et une surface arrière (R) ;
dans laquelle la surface arrière est pourvue d'une couche d'oxyde tunnel (12) et d'une couche de polysilicium dopé (14) de conductivité de type n ; la couche d'oxyde tunnel et la couche de polysilicium dopé de conductivité de type n formant un empilement de couches à motif pourvu d'espaces (A) dans l'empilement de couches à motif ;
**caractérisée en ce qu'**un contact en alliage Al-Si (16 ;160,161,162) est agencé à l'intérieur de chacun des espaces, en contact électrique avec une couche de base (10) du substrat, et
un ou plusieurs contacts Ag ou contacts de métal de transition (18) sont agencés sur la couche de polysilicium dopé à motif et en contact électrique avec la couche de polysilicium dopé à motif (14).

2. Cellule solaire selon la revendication 1, comprenant une couche de polysilicium intrinsèque (26 ;54-1) bordant la couche de polysilicium dopé à motif (14) de conductivité de type n et recouvrant la surface arrière du substrat de silicium dans l'espace, l'oxyde tunnel étant en outre agencé entre la couche de polysilicium intrinsèque et la surface arrière du substrat de silicium dans les espaces et les contacts Al-Si s'étendant à travers la couche de polysilicium intrinsèque (26 ;54-1) et la couche d'oxyde tunnel (12).

3. Cellule solaire selon la revendication 1, dans laquelle une couche diélectrique hydrogénée (20 ;22 ;24) est agencée pour recouvrir les espaces et la couche de polysilicium dopée à motifs, les contacts d'Al-Si et les contacts d'Ag ou les contacts de métal de transition s'étendant chacun à travers la couche diélectrique hydrogénée, et facultativement dans laquelle la couche diélectrique hydrogénée présente une charge de surface négative.

4. Cellule solaire selon la revendication 3, dans laquelle la couche diélectrique hydrogénée (20 ;22 ;24) comprend une couche d'Al₂O₃ ou un empilement de couche d'a-SiNₓ:H et une couche d'Al₂O₃, avec la couche d'Al₂O₃ entre la couche d'a-SiNₓ:H et les espaces et la couche de polysilicium dopé à motif.

5. Cellule solaire selon la revendication 2, dans laquelle une couche diélectrique fournissant de l'hydrogène (22 ;44) est agencée pour recouvrir la couche de polysilicium intrinsèque (26) et la couche de polysilicium dopé à motif (14), les contacts d'Al-Si et les contacts d'Ag ou les contacts de métal de transition s'étendant chacun à travers la couche diélectrique fournissant de l'hydrogène, et facultativement dans laquelle la couche diélectrique fournissant de l'hydrogène comprend une couche d'a-SiNₓ:H, une couche d'Al₂O₃ ou un empilement d'une couche d'a-SiNₓ:H et d'une couche d'Al₂O₃.

6. Cellule solaire selon l'une quelconque des revendications 2-5, dans laquelle un corps de contact d'Ag (18) borde les contacts d'Al-Si (16) sur la couche de polysilicium intrinsèque (26).

7. Cellule solaire selon la revendication 3, dans laquelle l'Ag est basé sur un matériau de pâte d'Ag de cuisson traversante.

8. Cellule solaire selon la revendication 7, dans laquelle les contacts d'Al-Si (16) et les contacts d'Ag ou les contacts de métal de transition (18) sont agencés sous la forme d'électrodes interdigitées entre une première barre omnibus (118) connectant les contacts d'Ag ou les contacts de métal de transition et une seconde barre omnibus (116) connectant les contacts d'Al-Si ; les barres omnibus s'étendant le long de la surface arrière dans une direction perpendiculaire à une longueur des électrodes interdigitées, et l'électrode interdigitée d'Al-Si comprend une pluralité de contacts d'Al-Si individuels agencés le long de la longueur de l'électrode interdigitée, la pluralité de contacts d'Al-Si étant interconnectés par un corps allongé en Al ou en alliage d'Al-Si s'étendant au-dessus de la pluralité de contacts d'Al-Si.

9. Cellule solaire selon l'une quelconque des revendications 7 et 8, dans laquelle une partie de l'électrode interdigitée d'Al-Si (16) s'étend latéralement sur une partie de la couche de polysilicium dopée à motif limitrophe (14) de conductivité de type n.

10. Cellule solaire selon la revendication 2, dans laquelle des ouvertures tracées au laser sont positionnées dans la couche diélectrique au-dessus d'emplacements des espaces (A).

11. Cellule solaire selon l'une quelconque des revendications 3 à 6, dans laquelle des ouvertures tracées au laser sont positionnées dans la couche diélectrique hydrogénée au-dessus des espaces (A) dans lesquels les contacts d'Al-Si (16) sont positionnés, et des ouvertures tracées au laser sont positionnées dans la couche diélectrique hydrogénée dans laquelle les contacts d'Ag ou les contacts de métal de transition (18) sont positionnés au-dessus de la couche de polysilicium dopé à motif (14) de conductivité de type n, et facultativement dans laquelle l'Ag est à base d'un matériau en pâte à base d'Ag sans cuisson traversante.

12. Cellule solaire selon l'une quelconque des revendications précédentes 1 à 11, comprenant en outre une couche diélectrique sur la surface avant, la couche diélectrique étant configurée avec une charge de surface négative, et facultativement comprenant en outre sur la surface avant une couche de polysilicium intrinsèque qui est recouverte par une couche diélectrique fournissant de l'hydrogène.

13. Cellule solaire selon la revendication 5, dans laquelle le contact d'Al-Si est bordé au niveau de ses bords par des éléments de délimitation (28) agencés sur la couche diélectrique fournissant de l'hydrogène (22), les éléments de délimitation étant constitués d'un matériau caractérisé en tant que matériau inerte par rapport au matériau de couche diélectrique fournissant de l'hydrogène et à l'aluminium.

14. Procédé de fabrication d'une cellule solaire à contact arrière (1 ;2 ;3 ;908 ;1008) à base d'un substrat de silicium (10) de conductivité de type p présentant une surface avant (F) pour recevoir un rayonnement et une surface arrière (R) ;
le procédé comprenant les étapes consistant à :
fournir sur la surface arrière un empilement de couches d'une couche d'oxyde tunnel (12) et d'une couche de polysilicium dopé (14) de conductivité de type n, la couche d'oxyde tunnel étant agencée entre la surface arrière et la couche de polysilicium dopé ;
structurer l'empilement de couches pour qu'il y ait des espaces dans l'empilement de couches ;
**caractérisé par** les étapes consistant à :
agencer des contacts en alliage Al-Si (16 ; 160,161,162) à l'intérieur de chacun des espaces, en contact électrique avec une couche de base du substrat (10), et
agencer un ou plusieurs contacts d'Ag ou contacts de métal de transition (18) sur la couche de polysilicium dopé de l'empilement de couches à motif et en contact électrique avec ladite couche de polysilicium dopé.

15. Procédé selon la revendication 14, dans lequel la structuration de l'empilement de couches (12, 14) avec des espaces (A) dans l'empilement de couches comprend le dépôt ou la création d'une couche de recouvrement (40) comprenant une couche de SiO₂ et/ou une couche de SiNₓ et la structuration de la couche de recouvrement en créant des ouvertures (42) dans la couche de recouvrement au moyen d'un retrait local de ladite couche de SiO₂ et/ou de la ou des couches de SiNₓ par un faisceau laser (50), et comprenant en outre facultativement un retrait de la couche de recouvrement à motif (40-1) pour exposer la couche de polysilicium dopée (14) ;
déposer sur la surface arrière, au-dessus des espaces et de la couche de polysilicium dopé à motif exposée, une couche diélectrique (44), et
créer des ouvertures dans la couche diélectrique au niveau de l'emplacement (62) des espaces au moyen d'un faisceau laser (60).

16. Procédé de fabrication d'une cellule solaire à contact arrière (1008) à base d'un substrat de silicium (10) de conductivité de type p présentant une surface avant (F) pour recevoir un rayonnement et une surface arrière (R) ; le procédé comprenant les étapes consistant à :
fournir sur la surface arrière un empilement de couches d'une couche d'oxyde tunnel (12) et d'une couche de polysilicium intrinsèque (54), la couche d'oxyde tunnel étant agencée entre la surface arrière et la couche de polysilicium intrinsèque ;
recouvrir l'empilement de couches (12, 54) avec une couche de recouvrement (40) comprenant une couche de SiO₂ et/ou une couche de SiNₓ et créer un motif (41) de zones de couche de SiO₂ et/ou de couche de SiN frittées dans la couche de recouvrement ;
éliminer les zones de couche de SiO₂ et/ou de couche de SiNₓ (40-2) qui n'ont pas été frittées ;
exposer la couche de polysilicium intrinsèque (54) non recouverte par le motif de zones de couche(s) de SiO₂ et/ou de SiNₓ frittées à une espèce de dopant de type n, de manière à créer un motif de zones de couche de polysilicium dopé de type n (14) lorsqu'elles ne sont pas recouvertes par la ou les couches de SiO₂ et/ou de SiNₓ frittées ;
retirer les zones de couche(s) de SiO₂ et/ou de SiNₓ frittées à motifs de manière à exposer une ou plusieurs zones de silicium polysilicium intrinsèque (54-1) ;
**caractérisé par** les étapes consistant à :
agencer des contacts en alliage d'Al-Si sur lesdites une ou plusieurs zones de polysilicium intrinsèque, chacune en contact électrique avec la zone respective de polysilicium intrinsèque, et
créer des contacts d'Ag ou des contacts de métal de transition sur une ou plusieurs des zones de couche de silicium polysilicium dopé de type n à motif et en contact électrique avec lesdites zones de couche de silicium polysilicium dopé de type n à motif, et facultativement,
dans lequel le motifs de zones de couche de SiO₂ fritté et/ou de couche de SiNₓ est créé en utilisant un faisceau laser comme source de chaleur locale pour un frittage.

17. Procédé selon la revendication 16, comprenant en outre les étapes consistant à :
après ledit retrait des zones de couche(s) de SiO₂ et/ou de SiNₓ frittées à motif, déposer une couche diélectrique (44) au-dessus des zones de polysilicium intrinsèque (54-1) et des zones de polysilicium dopé de type n (14), et
pour une ou plusieurs zones de polysilicium intrinsèque, créer un espace ou une ouverture au niveau d'un emplacement dans la couche diélectrique recouvrant la zone de polysilicium intrinsèque ; dans lequel l'espace ou l'ouverture dans la couche diélectrique recouvrant la zone de polysilicium intrinsèque est créé en utilisant un faisceau laser (60).
